Europäisches Patentamt

European Patent Office

Office européen des brevets

(11) Veröffentlichungsnummer: **0 078 884**
**A2**

(12) **EUROPÄISCHE PATENTANMELDUNG**

(21) Anmeldenummer: **82106209.8**

(51) Int. Cl.³: **H 04 B 3/14**

(22) Anmeldetag: **12.07.82**

(30) Priorität: **24.10.81 DE 3142203**

(43) Veröffentlichungstag der Anmeldung:
**18.05.83 Patentblatt 83/20**

(84) Benannte Vertragsstaaten:
**BE DE FR GB IT LU NL**

(71) Anmelder: **AEG - TELEFUNKEN Nachrichtentechnik GmbH**
**Gerberstrasse 33**
**D-7150 Backnang(DE)**

(72) Erfinder: **Lenz, Sigmund, Dipl.-Ing.**
**Kernerstrasse 17**
**D-7152 Aspach 1(DE)**

(72) Erfinder: **Weber, Herbert, Ing.-grad.**
**Robert-Bosch-Strasse 1**
**D-7150 Backnang(DE)**

(74) Vertreter: **Schickle, Gerhard, Dipl.-Ing. et al,**
**Licentia Patent-Verwaltungs-GmbH Theodor-Stern-Kai 1**
**D-6000 Frankfurt/Main 70(DE)**

(54) **Entzerrer.**

(57) Entzerrer mit zwei Kanälen (2...3 und 5...11) die in einer Addieranordnung (K2) münden und von denen der erste Kanal (2...3) linear ist und der zweite (5...11) eine nichtlineare Anordnung enthält. Zur Vereinfachung der Einstellung weist die nichtlineare Anordnung zwei Zweige (6...9 und 7...8) auf, die zur Addition zusammengeführt sind und von denen der erste Zweig (6...9) linear und der zweite (7...8) nichtlinear ist in der Weise, dass bei der Addition die Signale aus dem ersten Zweig (6...9) durch gegenphasige Signalanteile (f1, f2) aus dem zweiten Zweig (7...8) kompensiert werden.

FIG.1

Licentia Patent-Verwaltungs-GmbH          Z13 PTL-BK/Ruf/ma
Theodor-Stern-Kai 1                       BK 81/74
D-6000 Frankfurt 70


Entzerrer


Die Erfindung betrifft einen Entzerrer nach dem Oberbegriff
des Patentanspruches 1. Ein solcher Entzerrer ist bekannt aus
der DE-OS 23 52 569. Ebenso wie die darin beschriebene Phasenkorrekturanordnung kann der vorliegende Entzerrer für die Vorentzerrung frequenzmodulierter Signale dienen, die einer Wanderfeldröhre oder einer anderen nichtlinearen Anordnung zugeführt werden sollen, welche Phasenverzerrungen und Amplitudenverzerrungen erzeugt. Die vorliegende Einrichtung kann aber
auch zur Nachentzerrung dienen oder in einem Rückkopplungszweig angeordnet sein. Bevorzugt ist aber an die Verwendung
als Vorentzerrer gedacht, wobei die den Entzerrer verlassenden
Signale einen zur linearisierenden Verstärker steuern. Durch
die Vorentzerrung soll der Intermodulationsabstand am Ausgang
des zu linearisierenden Verstärkers verbessert werden. Die
Schwierigkeit besteht dabei darin, Phase und Amplitude der
vom Entzerrer gelieferten Signale richtig einzustellen.


Dementsprechend ist es Aufgabe der Erfindung, einen Entzerrer
zu schaffen, der sich möglichst leicht einstellen läßt.


Diese Aufgabe wird gelöst durch den Entzerrer mit den Merkmalen des Patentanspruches 1. Vorteilhafte Weiterbildungen sind
in den Unteransprüchen angegeben.

Dabei ist zunächst von folgender Überlegung ausgegangen worden:
Wie beim Stand der Technik wird ein eingespeistes, beispielsweise sinusförmiges Signal zunächst über eine Verzweigung in
zwei getrennte Kanäle aufgeteilt, welche unterschiedliche
Übertragungsfunktionen besitzen. Der erste Kanal läßt das
eingespeiste Signal (Nutzsignal) unverzerrt passieren, während der zweite Kanal, auch Kompensationskanal genannt, das
eingespeiste Signal über eine nichtlineare Kennlinie weiter
verarbeitet. Unterdrückt man nun im Kompensationskanal das
eigentliche Nutzsignal, dann sind nur noch Amplitudenanteile höherer Ordnung vorhanden, welche über eine Addieranordnung mit dem ersten Kanal zusammengefaßt werden, so daß eine resultierende Übertragungsfunktion nach Art einer Kennlinie entsteht, die, verglichen mit der Kennlinie des zu entzerrenden Verstärkers, dessen Linearisierung bewirkt. Für einen Wanderfeldröhrenverstärker, dessen Übertragungskennlinie einer Begrenzerkennlinie ähnelt, hat der Entzerrer eine
resultierende Übertragungsfunktion nach Art einer Expanderkennlinie.

Anhand der Zeichnung wird eine Ausführungsbeispiel der Erfindung erläutert und eine noch anschaulichere Erklärung für die
Funktionsweise der Erfindung gegeben:
Figur 1 zeigt ein Blockschaltbild eines Entzerrers und
Figur 2 ein etwas detaillierteres Blockschaltbild mit einem
nachgeschalteten, zu entzerrenden Verstärker.

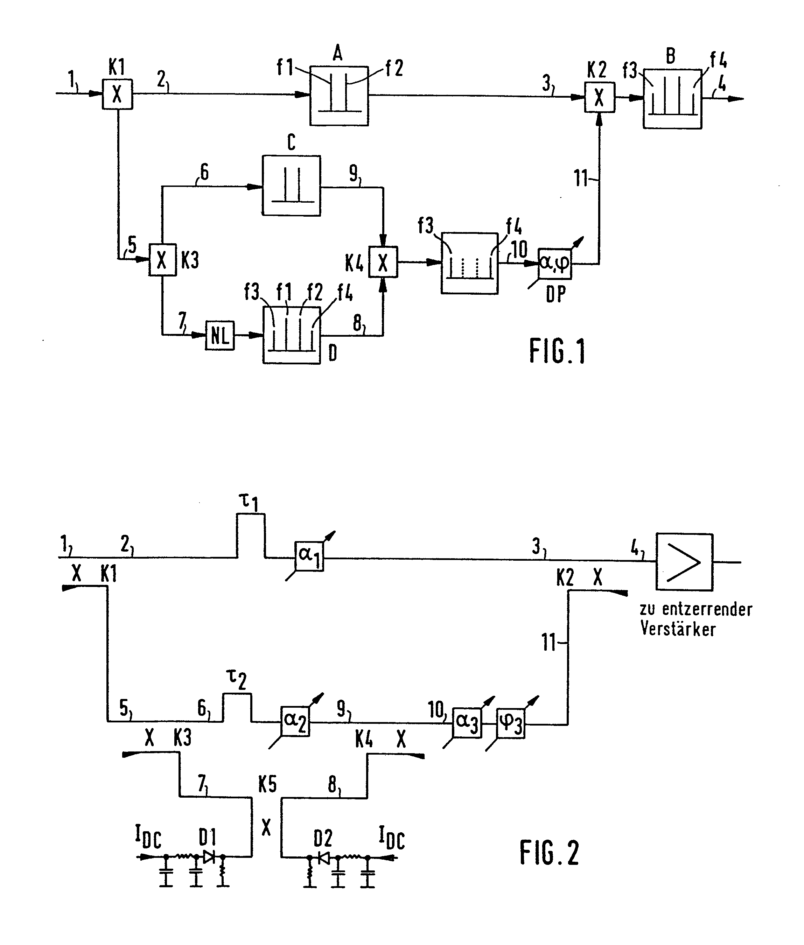

In Figur 1 gelangt ein eingespeistes Signal, das aus zwei
Schwingungen mit unterschiedlichen, im Übertragungsbereich
liegenden Frequenzen besteht, vom Entzerrereingang 1 über
eine Verzweigung K1 auf einen ersten Kanal 2...3 und von
dort zu einer Addieranordnung K2 und zum Entzerrerausgang 4.

In dem linearen ersten Kanal 2...3 ist innerhalb eines Rahmens A die spektrale Verteilung des eingespeisten Signals mit den beiden Spektrallinien bei den Frequenzen f1, f2 dargestellt. Am Entzerrerausgang 4 sollen, vergleiche den Rahmen B, Spektrallinien bei den Frequenzen f3 und f4 hinzugekommen sein als Vorentzerrung für Intermodulationsprodukte, die in einem dem Entzerrerausgang 4 nachzuschaltenden und zu entzerrenden Verstärker auftreten.

Um diese zusätzlichen Spektrallinien zu erzeugen, ist von der Verzweigung K1 ausgehend ein zweiter Kanal (Kompensationskanal) 5...10...11 vorgesehen. Er enthält ausgehend von einer weiteren Verzweigung K3 zwei Zweige 6...9 bzw. 7...8, die zur Addition in einem Additionsnetzwerk K4 zusammengeführt sind.

Der erste Zweig arbeitet linear, wie das Spektrum im Rahmen C andeutet, während im zweiten Zweig 7...8 durch eine nichtlineare Anordnung NL definiert Intermodulationssignale neben dem eigentlichen Nutzsignal erzeugt werden, wie im Rahmen D angedeutet.

Der lineare erste Zweig 6...9 wird dazu verwendet, die auf einer Leitung 5 der Verzweigung K3 zugeführten Signale auf der Ausgangsleitung des Additionsnetzwerkes K4 zu unterdrükken, um dort ein Spektrum zu erhalten, welches nur aus Intermodulationslinien (f3, f4) besteht. Wird dieses über einstellbare Dämpfungsglieder und Phasenschieber DP und über eine Leitung 11 an die Addieranordnung K2 gegeben, so liegt nach Addition der Signale aus dem ersten und dem zweiten Kanal am Entzerrerausgang 4 das im Rahmen B gezeigte Spektrum vor, welches außer den eigentlich zu übertragenden Nutzsignalen mit den Frequenzen f1, f2 noch Intermodulationsterme enthält (f3, f4), die in Amplitude und Phase mittels der Dämpfungsglieder und Phasenschieber DP einstellbar sind. Im nachfolgenden Verstärker erzeugte, gegenphasige Intermodultionssignale bewirken am Verstärkerausgang eine Intermodulationsentzerrung.

0078884

BK 81/74

Besonders vorteilhaft bei der gezeigten Anordnung ist die Tatsache, daß auf dem Leitungszug 10...11 im wesentlichen nur Intermodulationsprodukte vorhanden sind, so daß der erste Kanal 2...3 weitestgehend vom Kompensationskanal 5...11 entkoppelt ist, so daß Betrag und Phase der auf der Leitung 4 vorliegenden Nutz- und Vorverzerrungssignale getrennt eingestellt werden können.

Anhand von Figur 2 wird noch näher auf ein schaltungstechnisches Ausführungsbeispiel zur Anordnung nach Figur 1 eingegangen unter Verwendung der gleichen Bezugszeichen. Es sind folgende Baugruppen verwendet:
K1...K5 Koppelnetzwerke, z.B. 3 dB - 90°-Hybridkoppler als Verzweigungen bzw. Addieranordnung oder Additionsnetzwerk,

$\tau_1, \tau_2$ Umwegleitungen zum Laufzeitausgleich,

$\alpha_1,...\alpha_3$ variable Dämpfungsglieder, z.B. mit PIN-Dioden,
$\varphi_3$ Phasenschieber zur Feineinstellung der Phase der Intermodulationsprodukte,
D1, D2 Schottky-Barier-Dioden zur Erzeugung der nichtlinearen Kennlinie.

Das Dämpfungsglied $_3$ dient dabei zur Feineinstellung der Amplitude der Intermodulationsprodukte auf den Leitungszug 10...11.

Bei der Dimensionierung der Koppelnetzwerke ist besonders zu beachten, daß an den Koppeltoren der Amplituden- und Phasengang maximal flach wird, da beide unmittelbar mit der erreichbaren Entzerrung verknüpft sind.

. . . . . . . . . . . . .

Licentia Patent-Verwaltungs-GmbH          Z13 PTL-BK/Ruf/ma
Theodor-Stern-Kai 1                        BK 81/74
D-6000 Frankfurt 70

Patentansprüche

1. Entzerrer mit zwei Kanälen, die von einer Verzweigung (K1) ausgehen, in einer Addieranordnung (K2) münden und von denen der erste Kanal (2...3) linear ist und der zweite (5... 11) eine nichtlineare Anordnung enthält, dadurch gekennzeichnet, daß die nichtlineare Anordnung zwei Zweige (6... 9 und 7...8) aufweist, die zur Addition (K4) zusammengeführt sind und von denen der erste Zweig (6...9) linear und der zweite (7...8) nichtlinear ist in der Weise, daß bei der Addition die Signale aus dem ersten Zweig (6...9) durch gegenphasige Signalanteile (f1, f2) aus dem zweiten Zweig (7...8) kompensiert werden.

2. Entzerrer nach Anspruch 1, dadurch gekennzeichnet, daß in wenigstens einem Kanal und/oder Zweig ein Laufzeitausgleichsglied ($\tau_1$, $\tau_2$) vorgesehen ist.

3. Entzerrer nach Anspruch 1, dadurch gekennzeichnet, daß in wenigstens einem Kanal und/oder Zweig ein einstellbares Dämpfungsglied ($\alpha_1$, $\alpha_2$, $\alpha_3$) vorgesehen ist.

4. Entzerrer nach Anspruch 1, <u>dadurch gekennzeichnet,</u> daß in wenigstens einem Kanal und/oder Zweig ein einstellbarer Phasenschieber ($\varphi_3$) vorgesehen ist.

5. Entzerrer nach Anspruch 1, <u>dadurch gekennzeichnet,</u> daß der zweite Zweig (7...8) als nichtlinearer Verstärker ausgebildet ist.

6. Entzerrer nach Anspruch 1, <u>dadurch gekennzeichnet,</u> daß der zweite Zweig (7...8) als Diodennetzwerk ausgebildet ist.

FIG.1

zu entzerrender
Verstärker

FIG.2